# EUROPEAN PATENT APPLICATION

(11) **EP 1 821 108 A1**
(43) Date of publication of application: **22.08.2007**
(21) Application number: 07102321.2
(22) Date of filing: 14.02.2007
(51) Int. Cl.: G01R 31/02, G01R 31/04

(54) **Method and apparatus for condition monitoring of electrical connections**

(30) Priority: 21.02.2006 FI 20065125
(71) Applicant: ABB Oy, 00380 Helsinki (FI)
(72) Inventor: Miettinen, Erkki, 00170, Helsinki (FI)
(74) Representative: Valkeiskangas, Tapio Lassi Paavali

(57) **Abstract**

A method and arrangement for determining the condition of connectors of an energized device. The method comprises the steps of determining the temperature of connectors carrying a current of a substantially equal magnitude, comparing the differences between the temperatures of the connectors and detecting an increase in the temperature difference between connectors of the device as an indication of a failure in the connection concerned.

## Description

### BACKGROUND OF THE INVENTION

The invention relates to the condition monitoring of electrical connections and particularly to a method and apparatus for detecting failures in connections between cables and bus bars, for example.

In the industrial sector and in buildings there is often need for high-power electrical equipment, which typically contain bolt joints between cables and the connectors of the equipment. An example of such equipment is a high-power frequency converter. Since the connections are made during the installation of the equipment, it is possible that the joint is not sufficiently tightened. This may result to increasing transfer resistance that causes overheating in the joint, which in turn may damage the structures and, in an extreme case, set fire to the insulating materials.

For this reason it is customary to periodically inspect the connections in the most important areas and in those most sensitive to interruptions by means of thermal imaging cameras to reveal excessive heating.

Thermal imaging is not only expensive, due to the high price of the equipment, but also somewhat dangerous and slow, because to allow thermal imaging to be carried out and overheating to be detected it is typically necessary to open both the door of the cabinet enclosing the equipment to be imaged and to remove shrouds, or the like, although the equipment is live and loaded. Moreover, modern equipment and cabinets are very compact in structure and therefore cable connections often have to be arranged so that thermal imaging is not possible without mirrors or other special arrangements.

Due to the above difficulties and risks, thermal imaging on equipment level is possibly carried out only once a year, which is often not enough for detecting a rapidly advancing failure in a connection. Consequently, the equipment and the cables may be destroyed, due to which the manufacturing process may come to a halt for days or for weeks even. It is obvious that the magnitude of the damage thus caused may exceed manifold the price of the equipment and the cabling.

### BRIEF DESCRIPTION OF THE INVENTION

It is therefore an object of the invention to provide a method and an apparatus implementing the method to allow the condition of connections to be monitored more reliably and safely than before. The object of the invention is achieved by a method and arrangement characterized by what is stated in the independent claims. The preferred embodiments of the invention are disclosed in the dependent claims.

The invention is based on monitoring the temperatures of connections individually, wherein a deviation in the temperature of an individual connection as compared with other connections in the same system will indicate a failure in the former.

An advantage of the method and arrangement of the invention is safety, which is significantly improved because the operation according to the invention does not require any visual inspections of the equipment. In addition, the invention allows failures that are only starting to develop to be detected in time, because the measurement frequency may be multiplied compared to before, and the measurement may even be carried out in real-time. Moreover, failures in connections are easy to detect well in advance, which allows repairs to be scheduled at a time which least interferes with the manufacturing process or other operation.

### BRIEF DESCRIPTION OF THE FIGURES

In the following the invention will be disclosed in connection with preferred embodiments and with reference to the accompanying drawings, in which
Figure 1 illustrates a circuit solution according to an embodiment of the invention;
Figure 2 illustrates the output frequency of the circuit of Figure 1 as a function of temperature; and
Figure 3 illustrates an example of temperatures determined by the method of the invention as a function of time.

### DETAILED DESCRIPTION OF THE INVENTION

In high-power equipment electrical cable connections are usually placed to terminal connectors provided on peripheral areas of the equipment, the connectors resting on an insulating block injection-moulded from an insulating material. A terminal connector usually has a fastening bolt whose head is on the underside of the connector, embedded in the insulating block in such a way that it cannot rotate when the connection is tightened. When current passes through this connection, the heat created in the transfer resistance of the connection is transferred both to the terminal connector and the cable. Because of a good thermal contact, also heat generated in the cable alone, for example in a poor cable shoe connection, is detectable from the connector.

According to the method of the invention, the condition of a connection between connectors of energized equipment may be determined by measuring the temperature of these connectors, which carry a current of a substantially equal magnitude. Such connectors include those between the supply cables of a three-phase apparatus, such as a three-phase frequency converter, and the internal wiring of the frequency converter. Such internal wirings are typically implemented in a manner known in the art by using rigid bus bars. Other possible connections in a frequency converter could be those at the intermediate circuit and at the output of the frequency converter, for example.

According to the method of the invention, a comparison between differences in the temperatures of the connectors is carried out next. This comparison may be carried out using a device specifically designed for this purpose, but most advantageously the comparison is made in the device whose connector temperatures are to be determined. For example, if the device is a frequency converter, it already contains computation capacity and therefore no separate processor or other similar component needs to be added for the comparison. The temperatures may be compared simply by determining the differences between temperatures measured at different stages, or the absolute values of these differences. It is obvious that there are various ways of comparing temperature differences.

According to the method, an increase detected in the temperature difference between the connectors of the equipment then indicates a failure in the connection between the connectors. This detection is preferably carried out in the same member as the comparison of the temperature differences, i.e. by using the processor of the device to be monitored, for example. The increase in the temperature difference may be detected on the basis of the comparison by detecting an increase in the difference or in the absolute value of the difference between temperatures at different stages. In practice this means that measurement values may be stored in a memory, these values then allowing a change in a temperature difference compared with an earlier difference to be detected.

Another way to detect a change is to observe temperature trends, whereby a deviation of a trend from other temperature trends allows an increase in the temperature difference to be detected. Other obvious alternatives for performing the detection include those based on temperature derivatives or on observation of changes in predetermined absolute temperatures and deviations in these changes as compared to one another.

It is to be noted that since current conductors made of metal conduct heat well, the method of the invention allows also a failure appearing at the connection between a cable and a cable shoe to be detected, even if the temperature were determined at the bus bar.

According to the invention a temperature-determining member, such as a temperature sensor, is placed into a gap between each coupling rail and insulation block. The sensor allows the temperatures of all connections and, more specifically, temperature differences between the connections to be monitored to detect whether there is any connection that shows a rise in temperature deviating from other similar connections and indicating a risk of failure. In the arrangement and method of the invention temperature sensors acceptable for the purpose include also inexpensive and inexact or non-linear components, because only proportional differences between connections loaded with a current of an equal magnitude are relevant to the method and arrangement.

Frequency converters typically contain power stage control electronics at the potential of either the negative rail or the centre DC of the intermediate circuit, the potentials belonging to those of the main circuit. It is easy and inexpensive to add a component to this electronics to enable the signals from the temperature sensors on the coupling rails to be converted to a format in which they can be processed as digital data either directly in the potential concerned or the data may be transmitted among other telecommunication traffic to an external data processing resource for failure risk analysis. In other words, the method and arrangement of the invention may be applied to frequency converters in a simple manner.

It is obvious that the external data processing resource may also communicate, via Internet for example, with an enterprise in charge of the servicing of the equipment. In such case the temperatures of all coupling rails of all equipment to be monitored are followed in real time - possibly several times per hour even - and the trends thereby automatically generated are easy to use for setting alarm criteria.

The arrangement of the invention is most preferably applied to the manufacture of a new device, such as a frequency converter, but the principle of the invention is applicable to existing devices as well.

In the arrangement of the invention a temperature sensor or a circuit configuration determining temperature is preferably disposed between the coupling rails and the insulating support pieces supporting the ends of the rails. For this purpose the insulating support piece is appropriately shaped to receive the sensor. According to a preferred embodiment of the invention the temperature-determining circuit is produced onto a circuit board, the circuit components being disposed on the upper surface of the board, whereas the lower surface of the circuit board is in contact with the bus bar. Since the circuit board is two-sided, with a copper layer also on the lower surface thereof, the heat of the bus bar is transferred reliably to the upper surface of the circuit board, where the actual measurement takes place. Moreover, a two-sided circuit board has a specific dielectric strength, and hence the under surface thereof may be coupled to an energized bus bar directly, without having to worry about insulation.

The insulating support piece is provided with a recess for accommodating the circuit board and for protecting it against impacts from outside. The recess thus provides a housing that keeps the sensor firmly in place.

It is obvious that commercially available sensors may be used to determine the temperatures of connections. However, the components in question are expensive because they are typically meant for determining a precise absolute temperature. The invention being based on the ratios of the measured temperatures, an absolute temperature is not relevant and therefore the method and arrangement of the invention may be implemented using inexact members for determining temperature.

Among the most inexpensive typical components for temperature measurement are an NTC resistor and the junction voltage of a signal diode. The former is most non-linear, and the signal in the latter is small and therefore very sensitive to interference. There are also various commercial components, significantly more expensive than the ones mentioned above, that can be used. They convert the temperature they sense either to voltage, current, frequency or directly into a digital format. Since the measurement results should preferably be suited for digital processing the signal needs to be digitized, in which case sensor components providing a digital signal directly are preferred.

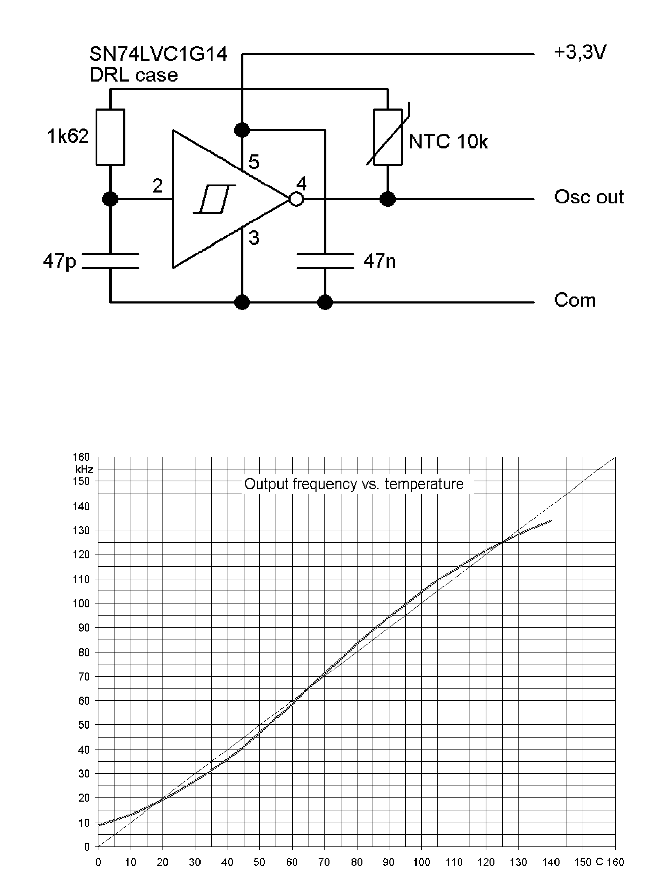

Figure 1 illustrates an example of a temperature-determining circuit configuration used in the method and arrangement of the invention. The Figure shows a coupling known per se and implemented using an oscillator provided by means of a Schmitt-trigger inverter, a capacitor and an NTC resistor, the oscillator supplying its output signal directly in a digital format. The coupling may be implemented using surface coupling components and without lead-throughs onto a small piece of circuit board, which is then placed underneath the coupling rail to be measured, the rear surface of the circuit board being pressed against the rail and the components being in the recess provided in the insulating block, as described above. The circuit board and the components thereon thus follow fairly accurately the temperature of the rail. The circuit board provides the necessary insulation between the rail and the measurement circuit, and by changing the outer dimensions of the circuit board it is possible to dimension the creeping distance.

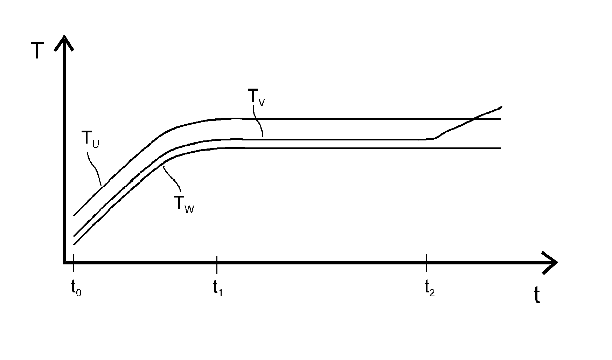

Since the NTC resistor obeys an exponential temperature dependence, resistance is not easily applicable as a temperature indicator. However, when combined with the oscillator and by introducing one additional linearisation resistor, it is possible to provide a circuit configuration that produces a non-linearity of a few degrees only within the most typical measurement range of +20 ... +140 degrees. Figure 2 illustrates the output frequency of the oscillator of Figure 1 as a function of the temperature of an NTC resistor. In other words, the output frequency of the oscillator of Figure 1 grows as temperature increases.

When the oscillator frequency is supplied to a calculator with a suitably adjusted gate time, the number of accumulated pulses in the case illustrated in Figures 1 and 2 is directly proportional to the temperature to be monitored. Hence the gate time preferably applied in the disclosed oscillator is one millisecond, and therefore an eight-bit binary calculator is sufficient. In this case each pulse added to the calculator corresponds to one degree. This type of calculator can be particularly easily and advantageously added separately to each channel, for example to an FPGA or ASIC circuit in charge of other control electronics in the device to be monitored, which means that external multiplexers or similar selection circuits are not needed. In practice the costs arising from the control of the quality of power connections are thus limited to the price of the sensor and that of the connector and the conductor thereof.

Figure 3 illustrates, for the sake of clarity, temperatures T_{U}, T_{V} and T_{W} of three connections determined according to the method of the invention. As shown in Figure 3, in this example the temperatures are determined using devices that are inexact as regards the absolute scale. A precise temperature value is therefore not known from any of the connections and all the temperatures deviate from one another due to an offset error. The example of Figure 3 assumes that at first the temperature of the connections of the device, such as a frequency converter, is the same as that of the ambient atmosphere, and at time instant to the loading of the frequency converter starts. In all phases, the temperatures of the connections behave in substantially the same way, i.e. as the loading increases the temperatures of the couplings rise substantially at the same rate of increase.

In the example the load is uniform and the couplings reach a substantially constant temperature at about time instant t₁. Due to the offset error there is a deviation in the temperatures of the different phases, which is substantially the same as at the initial time instant to.

However, at time instant t₂ the temperature T_{V} of one of the connections starts to rise in manner different from the others. With the method of the invention this exceptional temperature increase in the connection can be detected on the basis of temperature changes as compared with the other connections, differences between temperature derivatives or other similar aspects. On the basis of the detected change the device with the connections concerned may be switched off, if possible, or the monitoring of the temperatures may be continued possibly by subjecting the device in question to a smaller load.

The example of Figure 3 is simplified and mainly intended to illustrate the fact that the devices used in the method of the invention for determining temperature do not need to be absolutely precise, because deviations in the temperatures of a connection in relation to those of other connections can be detected with inexact means as well.

In the above disclosure the arrangement of the invention is implemented in connection with a circuit consisting of separate components for determining temperature. However, it is obvious that the method and arrangement of the invention may also be implemented using commercially available temperature measurement sensors. The circuit configuration disclosed above has also been given as one alternative temperature measurement circuit. Hence it is clear that there are various ways of implementing the circuit of the type in question.

A person skilled in the art will find it apparent that the basic idea of the invention may be implemented in various ways. The invention and its embodiments are therefore not restricted to the above examples but may be varied within the scope of the invention.

## Claims

1. A method for determining the condition of a connection between connectors in an energized device, **characterized in that** the method comprises the steps of
determining the temperature of connectors carrying a current of a substantially equal magnitude;
comparing the differences between the temperatures of the connectors; and
detecting an increase in the temperature difference between the connectors as an indication of a failure in the connection between the connectors of the device.

2. A method according to claim 1, **characterized in that** the determining of the temperature of the connectors comprises a step of determining the temperature in the vicinity of the connection.

3. A method according to claim 1, **characterized in that** the determining of the temperature of the connectors comprises a step of determining the temperature in a bus bar of an energized device, in the vicinity of the connection.

4. A method according to any one of the preceding claims 1 to 3, **characterized in that** the detecting of an increase in the temperature difference between connectors comprises a step of detecting when the temperature of one connector deviates from the temperatures of the other connectors.

5. A method according to any one of the preceding claims 1 to 4, **characterized in that** the method further comprises a step of generating an alarm signal in response to an increase in the temperature difference between the connectors.

6. An arrangement for determining the condition of a connection between connectors in an electrical device, **characterized in that** the arrangement comprises
means for determining temperature, the means being configured to determine the temperatures of connectors of an electrical device from connectors meant to carry currents of a substantially equal magnitude;
means for comparing temperatures, the means being configured to compare differences between the temperatures of the connectors; and
means for detecting an increase in the temperature differences between the connectors as an indication of a failure in the connection between the connectors of the electrical device.

7. An arrangement according to claim 6, **characterized in that** the means for determining temperature are arranged in the vicinity of the connection.

8. An arrangement according to claim 6, **characterized in that** the means for determining temperature are arranged on a bus bar of the electrical device, in the vicinity of the connection.

9. An arrangement according to any one of the preceding claims 6 to 8, **characterized in that** the means for detecting an increase in the temperature difference between the connectors are arranged to detect when the temperature of a connector deviates from the temperatures of the other connectors.

10. An arrangement according to any one of the preceding claims 6 to 9, **characterized in that** the arrangement further comprises means for generating an alarm signal in response to an increase in the temperature difference between the connectors.

11. An arrangement according to any one of the preceding claims 6 to 10, **characterized in that** the means for determining temperature are implemented onto a circuit board the lower surface of which is in contact with a bus bar of the electrical device and the upper surface of which has a temperature-determining coupling formed thereon.

12. An arrangement according to claim 11, **characterized in that** the circuit board is arranged into contact with the bus bar of the electrical device, the circuit board being inside an insulation piece supporting the bus bar.

13. An arrangement according to any one of the preceding claims 6 to 12, **characterized in that** the electrical device is a frequency converter.

14. A frequency converter comprising an arrangement according to any one of the preceding claims 6 to 12.
